Europäisches Patentamt

European Patent Office

Office européen des brevets

(11) Publication number: **0 097 535**
**A2**

# EUROPEAN PATENT APPLICATION

(21) Application number: **83303594.2**

(22) Date of filing: **22.06.83**

(51) Int. Cl.³: **H 01 J 49/46**

(30) Priority: **23.06.82 JP 108690/82**

(43) Date of publication of application:
**04.01.84 Bulletin 84/1**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Itakura, Toru**
**Kitazato-hausu 2 32-9, Sakuradai 1-chome**
**Isehara-shi Kanagawa 259-11(JP)**

(74) Representative: **Skone James, Robert Edmund et al,**
**GILL JENNINGS & EVERY 53-64 Chancery Lane**
**London WC2A 1HN(GB)**

(54) Crossed-field velocity filter and ion-beam processing system.

(57) A cross-field velocity filter for separating ions having a predetermined velocity comprises a pair of electrodes (11, 12) for producing a radial electric field and a pair of pole pieces (13, 14) for producing a magnetic field which crosses the electric field so that the crossed-field velocity filter has the same focusing properties for an ion beam in both the direction of the electric field and the direction of the magnetic field.

*Fig. 2A*

EP 0 097 535 A2

## CROSSED-FIELD VELOCITY FILTER AND ION-BEAM
## PROCESSING SYSTEM

The present invention relates to a crossed-field velocity filter (Wein filter) and to an ion-beam processing system in which the velocity filter is used.

Recently, ion-beam processing has been used for microstructure fabrication. In ion beam processing, a crossed-field (E x B) velocity filter is used to separate one species of particles from a beam consisting of a mixture of charged particles (ions) having different axial velocities v. The velocity v of a particle is related to its charge e, its mass m, and the acceleration potential V in accordance with the equation $v^2 = (2e/m)V$. Thus, differences in the velocity of various particles may be due to differences in the ratios of the charge to the mass (the ratio e/m). Assume that an electric field strength E and a magnetic field strength B are generated in the velocity filter. Particles having an axial velocity equal to E/B can pass through the filter without being deflected because the deflection force is cancelled whereas particles having a velocity other than E/B are deflected from their initial direction of travel.

One prior art crossed-field velocity filter comprises a pair of plate electrodes arranged in parallel and a pair of pole pieces arranged so that the magnetic field B formed by the pair of pole pieces crosses at right angles the electric field E formed by the pair of plate electrodes. In this crossed-field velocity filter, the electric field E and the magnetic field B are made uniform. An ion beam emitted from an ion source enters the crossed-field velocity filter from a direction orthogonal to both the electric field E and the magnetic field B. The ion beam is comprised of ions of a selected species and of ions of other species. By suitably adjusting the strengths of the electric field E and the magnetic field B, only the selected ion species can pass through the crossed-field velocity filter without being deflected while the ions of other species are deflected by a deflection force generated by an imbalance between the electric force and the magnetic force. Thus, the ion beam as it passes out of the velocity filter consists of only the selected ion species.

However, in the above-mentioned prior art velocity filter, when an ion beam passes therethrough, it is focused in only one direction, that is, it is focused in the directon of the electric field E and not in the direction of the magnetic field B. Accordingly, even if the incoming ion beam has a circular crosssection, the outgoing ion beam has an elliptical crosssection. Thus, the ion beam cannot be focused very narrowly, which factor is disadvantageous in microstructure fabrication, such as ion-beam etching or ion-beam exposure, which fabrication may be used as one of the processes of manufacturing semiconductor devices, the integration scale of which devices is increased in LSI and is further increased in super LSI, the pattern in LSI becoming finer and the pattern in super LSI becoming finer still.

In accordance with the invention a crossed-field velocity filter has a pair of electrodes for producing an electric field between them and a pair of pole pieces for producing a magnetic field which crosses the electric field so that the crossed-field velocity filter has the same focusing properties, for an ion beam entering a space between the electrodes and pole pieces, in both the direction of the electric field and the direction of the magnetic field.

With the present invention a crossed-field velocity filter is provided in which an ion beam can be focused in the directions of both the electric field and the magnetic field so that it is sufficiently narrowly focused.

Preferably the facing surfaces of the pair of electrodes form portions of surfaces of coaxial cylinders, the pair of electrodes being arranged so that an electric field formed between the electrodes is directed towards or radiates from the axis of the coaxial cylinders; the arrangement being such that a centre line parallel to the axis of the coaxial cylinders can be defined in a space surrounded by the pair of electrodes and the pair of pole pieces, the electric and magnetic fields in the space being orthogonal to the centre line and being orthogonal to each other at a point on the centre line so that a charged particle having a predetermined velocity passing through the space along the centre line is focused onto the centre line and a charged particle having a velocity other than the predetermined velocity is deflected from the centre line.

Some examples of filters in accordance with the present invention will now be described and contrasted with a prior art example with reference to the accompanying drawings, in which:-

Figure 1A is a perspective view of a prior art crossed-field velocity filter;

Figure 1B is a cross-sectional view of the filter of Fig. 1A;

Figure 1C is an explanatory view of an ion beam passing through the filter of Fig. 1;

Figure 2A is a perspective view of a crossed-field velocity filter in accordance with one embodiment of the present invention;

Figure 2B is a cross-sectional view of the filter of Fig. 2A;

Figure 2C is an explanatory view of the electric field in the filter of Fig. 2A;

Figure 3A is a cross-sectional view of a crossed-field velocity filter in accordance with another embodiment of the present invention;

Figure 3B is an explanatory view of the electric and magnetic fields in the filter of Fig . 3A; and,

Figure 4 is a perspective view of an ion beam processing system for carrying out an ion-processing method incorporating a crossed-field velocity filter according to the present invention.

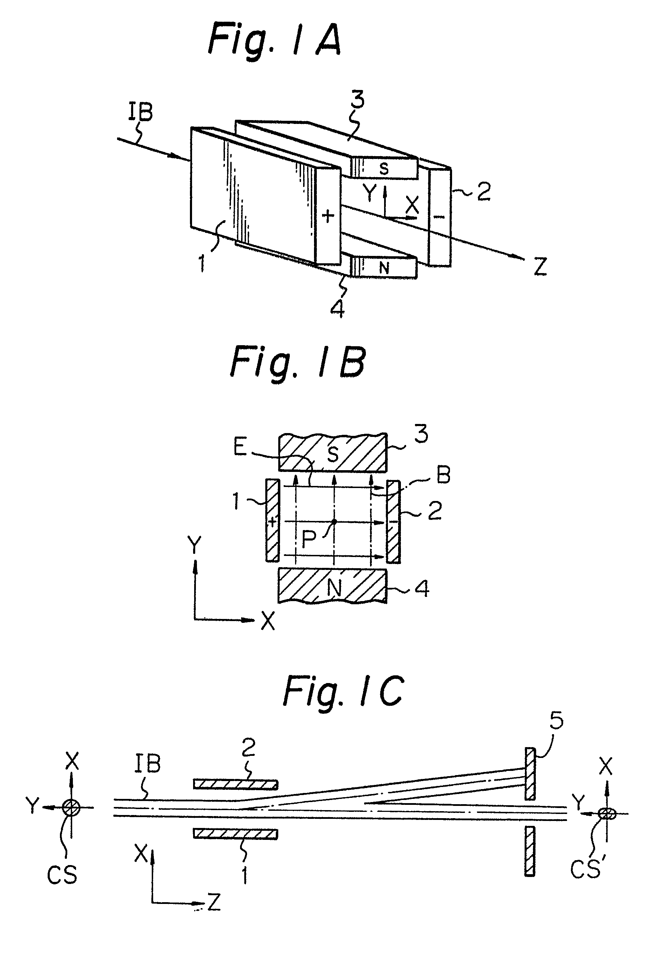

A perspective view of a prior art crossed-field velocity filter is illustrated in Fig. 1A, and a cross--sectional view of the crossed-field velocity filter of Fig. 1A is illustrated in Fig. 1B. The velocity filter of Fig. 1A comprises a pair of plate electrodes 1 and 2 and a pair of pole pieces 3 and 4. The pair of electrodes 1 and 2 are arranged so as to produce between them a uniform electric field E in the X direction. The pair of pole pieces 3 and 4 are arranged so as to produce a uniform magnetic field B in the Y direction. An ion beam IB is projected into the velocity filter along the Z axis. The electric force and the magnetic force exerted on the ions passing through the velocity filter are directed opposite to each other, and these two forces are cancelled only in the case of ions having a predetermined velocity.

Accordingly, if the entering ion beam consists of two species of ions having different velocities, i.e., one species of ions having a predetermined velocity and the other species of ions having a velocity other than the predetermined velocity, the entering ion beam is separated into two emerging ion beams as shown in Fig. 1C. One of the ion beams consists of the species of ions having the predetermined velocity, and this ion beam remains undeflected. On the other hand, the other ion beam consisting of the species of ions having a velocity other than the predetermined velocity is deflected by the velocity filter, and this ion beam can be readily removed with a separation aperture 5 as shown in Fig. 1C.

It is known that the crossed-field velocity filter of Fig. 1C has a focusing effect on the separated ion beam. However, this focusing effect is not axisymmetric, that is, the ion beam is focused only in the X direction and not in the Y direction. Accordingly, if the entering ion beam has a circular cross-section CS, the undeflected emerging ion beam has an elliptical cross-section CS'. This means that the emerging ion beam cannot be focused very narrowly.

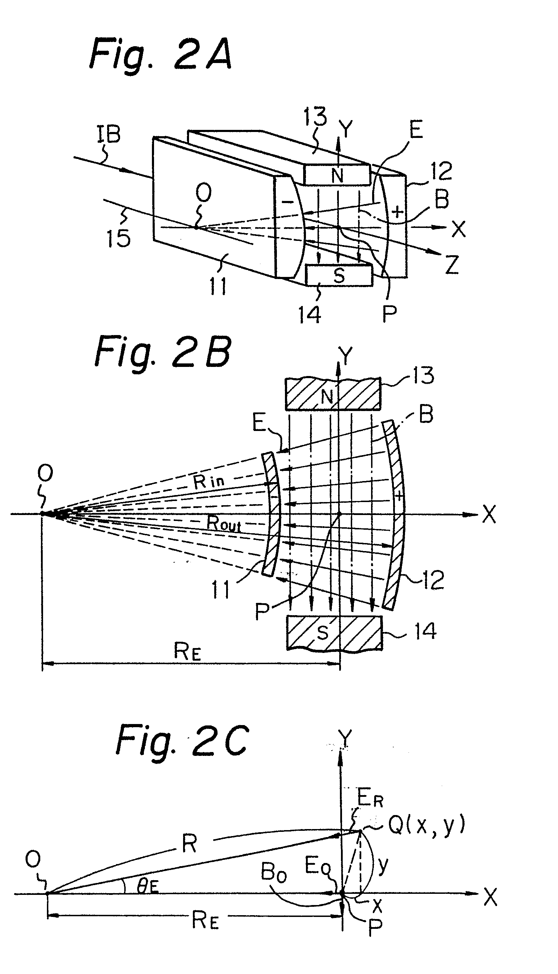

A crossed-field velocity filter in accordance with one embodiment of the present invention is described with reference to Figs. 2A, 2B, and 2C. A perspective view of the crossed-field velocity filter is illustrated in Fig. 2A. The crossed-field velocity filter of Fig. 2A comprises an inner electrode 11, an outer electrode 12, and a pair of pole pieces 13 and 14. The pole piece 13 is the N pole and the pole piece 14 is the S pole.

In the velocity filter of Fig. 2A, the facing surfaces of the inner electrode 11 and the outer electrode 12 are portions of two coaxial cylindrical surfaces. The axis 15 of these coaxial cylindrical surfaces is a line passing through a point O. By applying a negative potential to the inner electrode 11 and a positive potential to the outer electrode 12, a radial electric field E directed toward the axis 15 is formed between the electrode 11 and the electrode 12. On the other hand, the N pole piece 13 and the S pole piece 14 face each other in parallel, and, accordingly, a parallel magnetic field B is formed between the pole pieces 13 and 14.

The velocity filter of Fig. 2A is used for separating ions having a predetermined velocity from positive ions entering the filter along the Z axis in the direction of the arrow IB and for focusing the separated positive ions.

A cross-sectional view of the velocity filter of Fig. 2A in the X-Y plane is illustrated in Fig. 2B. As is shown in Fig. 2B, the radius of the inner electrode 11 is indicated by $R_{in}$, the radius of the outer electrode 12 is indicated by $R_{out}$, and a negative potential $-V_1$ and a positive potential $+V_1$ are applied to the inner electrode 11 and the outer electrode 12, respectively. The center of the incident ion beam is arranged so as to pass through the point P with a zero potential, the distance between the point P and the point O of the center of the coaxial cylindrical electrodes 11 and 12 is indicated by $R_E$, and the electric field strength at the point P is indicated by $E_O$ (Fig. 2C). The magnetic flux density of the magnetic field formed from the N pole piece 13 to the S pole piece 14 is indicated by $B_O$ (Fig. 2C). The electric and magnetic fields at the point P are orthogonal to each other.

The X axis is drawn to coincide with a line passing through the above-mentioned points O and P, and the Y axis is drawn to coincide with a line passing through the point P and being parallel to the direction of the magnetic field $B_O$. The distance $R_E$ between the points O and P is designed to satisfy the condition $R_E = 4V_O/E_O$ (herein, $V_O$ is the acceleration potential of an ion passing through the point P). The arrangement of the electrodes 11 and 12 and the pole pieces 13 and 14 is determined so as to satisfy the above-mentioned conditions.

In the velocity filter of Fig. 2A, the electric field strength $E_O$ and the magnetic flux density $B_O$ are adjusted to satisfy the following equation (1):

$$E_O = v_O B_O \qquad \qquad \dots\dots (1)$$

wherein $v_O$ is an ion velocity to be selected. Thus, ions having the velocity $v_O$ in the incident ion beam travel along the center line of the velocity filter (that is, the Z axis) without being deflected since the electric force and magnetic force exerted on the ions are balanced. On the other hand, ions having a velocity other than $v_O$ are deflected from the center line and are separated.

The ion beam emerging from the velocity filter of Fig. 2A is focused not only in the X direction but also in the Y direction. The focusing force exerted on the ions passing through the velocity filter is described in detail below.

Assume that an ion passes through an arbitrary point Q (x, y) in the velocity filter. The electric field at the point Q is illustrated in Fig. 2C. The distance between the points O and Q is indicated by R, the electric field strength at the point Q is indicated by $E_R$, and the potential at the point Q is expressed by $V_Q$. On the basis of the above, the following equations can be obtained:

$$E_R = E_O \cdot \frac{R_E}{R} \qquad \qquad \ldots\ldots \text{(a)}$$

$$R = \sqrt{(R_E + x)^2 + y^2} \qquad \ldots\ldots \text{(b)}$$

$$V_Q = E_O R_E \cdot \log \frac{R}{R_E} \qquad \ldots\ldots \text{(c)}$$

From these equations, the potential $V_Q$ is calculated as follows:

$$V_Q = E_O \cdot R_E \cdot \log \frac{\sqrt{(R_E + x)^2 + y^2}}{R_E}$$

$$= \frac{1}{2} E_O \cdot R_E \log \left(1 + \frac{2x}{R_E} + \frac{x^2 + y^2}{R_E^2}\right)$$

$$= \frac{E_O \cdot R_E}{2} \left[\frac{2x}{R_E} + \frac{y^2 - x^2}{R_E^2} + \text{---}\right]$$

By removing the higher order terms, the following equation (2) can be obtained:

$$V_Q = E_O(x + \frac{y^2 - x^2}{2R_E})  \qquad \dots\dots (2)$$

Assume that an ion passing through the velocity filter has a mass $m_O$ and an electric charge q. When the ion passes through the point P (having a zero potential), the ion has been accelerated by the potential $V_O$ , and the velocity $v_O$ is

$$v_O = \sqrt{\frac{2qV_O}{m_O}} \; .$$

On the other hand, when the ion passes through the point Q (having a potential $V_Q$), the ion has been accelerated by the voltage $(V_O - V_Q)$, and the velocity v is

$$v = \sqrt{\frac{2q(V_O - V_Q)}{m_O}} \; .$$

The velocity v is further calculated according to the equation (2):

$$v = \sqrt{\frac{2q}{m_O}\left\{V_O - E_O(x + \frac{y^2 - x^2}{2R_E})\right\}}$$

$$= \sqrt{\frac{2qV_O}{m_O}} \cdot \sqrt{1 - \frac{E_O}{V_O}(x + \frac{y^2 - x^2}{2R_E})}$$

$$= v_O \cdot \left\{1 - \frac{E_O}{2V_O}x - \frac{E_O(y^2 - x^2)}{4V_O R_E} + ---\right\}$$

by retaining up to first-order terms in x and y, the following equation (3) can be obtained:

$$v = v_O(1 - \frac{E_O}{2V_O}x)  \qquad \dots\dots (3)$$

The equation of motion in the X direction for the ion passing through the point Q is represented by the following equation (4):

$$m_O\ddot{x} = -q \cdot E_R \cos \theta_E + q \cdot v \cdot B_O  \qquad \dots\dots (4)$$

In this equation (4),

$$\cos \theta_E = \frac{R_E + x}{R} \; , \; E_R = E_O \cdot \frac{R_E}{R} \; , \text{ and}$$

$$v = v_O (1 - \frac{E_O}{2V_O} x).$$

Thus, the equation (4) can be replaced by the following equation:

$$m_O \ddot{x} = -q \cdot E_O \cdot R_E \frac{R_E + x}{R^2} + q \cdot v_O \cdot B_O (1 - \frac{E_O}{2V_O} x)$$

$$= \frac{-q \cdot E_O R_E \; (R_E + x)}{(R_E + x)^2 + y^2} + q \cdot v_O B_O (1 - \frac{E_O}{2V_O} x)$$

$$= -q E_O (1 - \frac{X}{R_E} + ---) + q v_O B_O (1 - \frac{E_O}{2V_O} x)$$

By retaining up to first-order terms in x and y and counting $E_O = v_O \cdot B_O$ and $R_E = 4V_O/E_O$ , the following equation (5) can be obtained:

$$m \ddot{x} = - \frac{q E_O^2}{4V_O} x \qquad \qquad \ldots\ldots (5)$$

The equation of motion in the Y direction for the ion passing through the point Q is represented by the following equation (6):

$$m_O \ddot{y} = -q \cdot E_R \cdot \sin \theta_E \qquad \ldots\ldots (6)$$

In the equation (6),

$$E_R = E_O \cdot \frac{R_E}{R} \; , \; \sin \theta_E = \frac{y}{R} \; , \text{ and}$$

$$R^2 = (R_E + x)^2 + y^2.$$

Thus, the equation (6) can be replaced by the following equation:

$$m_O \ddot{y} = -q E_O R_E \cdot \frac{y}{(R_E + x)^2 + y^2}$$

$$= -q E_O \frac{y}{R_E} (1 - \frac{2x}{R_E} + ---)$$

By retaining up to first-order terms in x and y, the following equation (7) can be obtained:

$$m_O \ddot{y} = -qE_O \frac{y}{R_E} \qquad \ldots\ldots (7)$$

The distance $R_E$ between the points O and P is selected to satisfy the following equation (8):

$$R_E = 4V_O/E_O \qquad \ldots\ldots (8)$$

Thus, the equaton (7) can be replaced by the following equation (9):

$$m_O \ddot{y} = -\frac{qE_O^2}{4V_O}y \qquad \ldots\ldots (9)$$

As can be seen from the equations (5) and (9), the equation of motion for the ion passing through the velocity filter has the same form in both the X direction and the Y direction. This means that the same focusing forces in the X direction and in the Y direction are exerted on the above-mentioned ion. Thus, the undeflected and selected ion beam is focused in both the X direction and the Y direction.

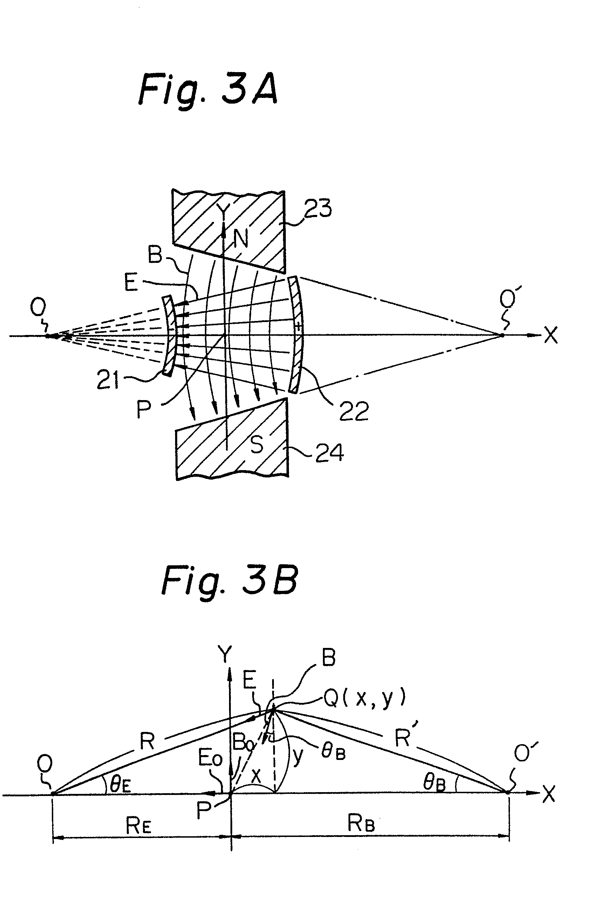

A crossed-field velocity filter in accordance with another embodiment of the present invention is now described with reference to Figs. 3A and 3B. A cross--sectional view of the velocity filter is illustrated in Fig. 3A. The velocity filter of Fig. 3A comprises a pair of electrodes 21 and 22 and a pair of pole pieces 23 and 24. In the velocity filter of Fig. 3A, the pole pieces 23 and 24 are arranged so as to face each other at sloping angles so that the magnetic field produced between them is coaxial with the curvature center O'. The electrodes 21 and 22 are arranged coaxially with the curvature center O so that the electric field produced between them is directed toward the curvature center O.

The electrodes 21 and 22 and the pole pieces 23 and 24 are arranged so that the electric field strength $E_O$ (Fig. 3B) and the magnet flux density $B_O$ (Fig. 3B) at the center point P of the velocity filter are orthogonal and so that the potential at the point P is zero. In the velocity filter of Fig. 3A, an ion having the velocity $v_O$ passing through the center point P is selected, as in the velocity filter of Fig. 2A.

The focusing force exerted on the ion passing through the velocity filter of Fig. 3A is described in detail with reference to Fig. 3B.

Assume that an ion passes through a point Q (x, y) in the velocity filter. The distance between the points O and P is $R_E$ , the distance between the points O' and P is $R_B$ , the distance between the points O and Q is R, and the distance between the points O' and Q is R'. The electric field strength at the point Q is E and the magnetic flux density at the point Q is B. The equation of motion in the X direction for the ion passing through the point Q is as follows:

$$m_O \ddot{x} = -qE \cos \theta_E + qv \cdot B \cos \theta_B \quad \ldots\ldots \quad (10)$$

As $B = \dfrac{B_O R_B}{R'}$ , $\cos \theta_B = \dfrac{R_B - x}{R'}$ ,

and $R' = \sqrt{(R_B - x)^2 + y^2}$, the equation (10) can be replaced by analysis by the following equation (11):

$$m_O \ddot{x} = -q \cdot E_O (\frac{E_O}{2V_O} - \frac{1}{R_E} - \frac{1}{R_B}) x \quad \ldots\ldots \quad (11)$$

On the other hand, the equation of motion in the Y direction for the ion passing through the point Q is as follows:

$$m_O \ddot{y} = -qE \sin \theta_E - qvB \sin \theta_B \quad \ldots\ldots \quad (12)$$

As $\sin \theta_B = \dfrac{y}{R'}$ , the equation (12) can be replaced by analysis by the following equation (13):

$$m_O \ddot{y} = -qE_O (\frac{1}{R_E} + \frac{1}{R_B}) y \quad \ldots\ldots \quad (13)$$

If the following equation (14) is satisfied, the equations of motion (11) and (13) have the same form.

$$\frac{1}{R_E} + \frac{1}{R_B} = \frac{E_O}{4V_O} \quad \ldots\ldots \quad (14)$$

Thus, by arranging the electrodes 21 and 22 and the pole pieces 23 and 24 so that the distance $R_E$ between the points O and P and the distance $R_B$ between the points O' and P satisfy the equation (14), the ion beam passing through the velocity filter is focused in both the X direction and the Y direction.

Though the above-mentioned two embodiments of the present invention are examples of crossed-field velocity filters having focusing properties in both the X direction and the Y direction for positive ions, it is possible to construct a crossed-field velocity filter having a focusing property for negative ions. In this case, the polarity of the electric field and the polarity of the magnetic field are reversed in the velocity filter of Fig. 2A or Fig. 3A. For example, in the velocity filter of Fig. 2A, the inner electrode 11 is applied with a positive potential, the outer electrode 12 is applied with a negative potential, the pole piece 13 is changed to an N pole, and the pole piece 14 is changed to a S pole.

The relation between the polarities of the ion charge, the electric field, and the magnetic field can be summarized as follows. If the current vector of the charged particle is indicated by $\vec{i}$ and the magnetic flux density vector is indicated by $\vec{B}$, an electrode positioned in a direction in which a right hand screw advances when it is turned in a direction from $\vec{i}$ to $\vec{B}$ is selected as the outer electrode and is applied with a potential having the same polarity as that of the ion charge. On the other hand, an opposite electrode is selected as the inner electrode and is applied with a potential having a polarity opposite to that of the ion charge. Thus, in accordance with the present invention, it is possible to construct a crossed-field velocity filter having a focusing property in two directions for both positively and negatively charged particles.

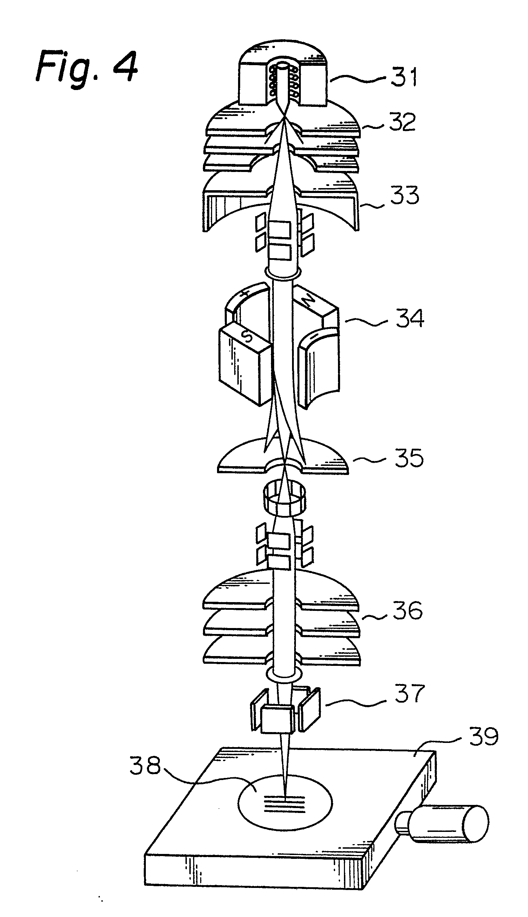

An ion-beam processing system using a crossed-field velocity filter is now described with reference to Fig. 4. The ion-beam processing system of Fig. 4 comprises an ion source 31, an extraction electrode 32, a condenser lens 33, a mass separator (a crossed-field velocity filter) 34, a separation aperture 35, an objective lens 36, a beam deflector 37, a target wafer 38, and a moving stage 39. The ion source 31 may be of any conventional type, such as a contact ionization source, radio frequency ionization source, plasmatron, LMI (liquid-metal ionization), etc. The ion beam emitted from the ion source 31 is extracted by the extraction electrode 32 and is focused into a parallel beam by the condenser lens 33. This ion beam enters the crossed-field velocity filter 34. The crossed-field velocity filter 34 has the construction shown in Fig. 2A or Fig. 3A. In the crossed-field velocity filter 34, only the selected species of ions travel along their path without being deflected while the other species of ions are deflected from their path. Thus, the undeflected ion beam emerging from the velocity filter 34 has only the selected species of ions therein, and it passes through the separation aperture 35. On the other hand, the deflected ion beam comprised of the other species of ions is removed by the separation aperture 35.

The selected ion beam emerging from the velocity filter is focused in both directions and into a first narrow image at a point near the separation aperture 35. Then the ion beam passing through the separation aperture 35 enters the objective lens 36 and is focused by the objective lens 36. The focused ion beam is projected onto the target wafer 38 through the beam deflector 37. The spot projected onto the wafer 38 by the ion beam has a circular shape. The surface of the wafer 38 is scanned by the ion beam deflected by the beam deflector 37.

According to the system of Fig. 4, the spot projected onto the wafer surface by the ion beam has a circular shape with a very narrow diameter. Therefore, it is very useful for high-resoluton ion-beam processing, such as ion-beam impurity injection, ion-beam etching, ion-beam exposure, etc.

- 16 -

C L A I M S

1.    A crossed-field velocity filter having a pair
of electrodes (11, 12) for producing an electric field
between them and a pair of pole pieces (13, 14) for
producing a magnetic field which crosses the electric
field so that the crossed-field velocity filter has the
same focusing properties, for an ion beam entering a
space between the electrodes and pole pieces, in both the
direction of the electric field and the direction of
the magnetic field.

2.    A crossed-field velocity filter according to
claim 1, wherein the facing surfaces of the pair of
electrodes (11, 12) form portions of surfaces of coaxial
cylinders, the pair of electrodes being arranged so that
an electric field (E) formed between the electrodes is
directed towards or radiates from the axis (O) of the
coaxial cylinders; the arrangement being such that a
centre line parallel to the axis of the coaxial cylinders
can be defined in a space surrounded by the pair of electrodes (11, 12) and the pair of pole pieces (13, 14), the
electric and magnetic fields in the space being orthogonal to the centre line and being orthogonal to each other
at a point (P) on the centre line so that a charged particle having a predetermined velocity ($V_o$) passing through
the space along the centre line is focused onto the
centre line and a charged particle having a velocity
other than the predetermined velocity is deflected from
the centre line.

3.    A crossed-field velocity filter according to
claim 2, wherein the predetermined velocity ($V_o$) is equal
to the ratio of the electric field strength ($E_o$) on the
centre line to the magnetic flux density ($B_o$) on the
centre line.

4.    A crossed-field velocity filter according to
claim 2 or claim 3, wherein the pole pieces (13, 14) have parallel facing surfaces so that the magnetic field (B) produced between the pole pieces is uniform.

5. A crossed-field velocity filter according to claim 4, wherein the distance ($R_E$) between the centre line and the axis of the coaxial electrodes (11, 12) is defined by the following relation

$$R_E = 4V_O/E_O,$$

where $E_O$ is the electric field strength on the centre line, and $V_O$ is the predetermined velocity.

6. A crossed-field velocity filter according to claim 2 or claim 3, wherein the facing surfaces of the pole pieces slope towards each other so that the magnetic field (B) produced between the pole pieces comprises coaxial lines of flux.

7. A crossed-field velocity filter according to claim 6, wherein the distance ($R_E$) between the centre line and the axis of the coaxial electrodes (11, 12) and the distance ($R_B$) between the centre line and the centre of curvature of the coaxial magnetic flux lines of the magnetic field satisfy the following relation:

$$\frac{1}{R_E} + \frac{1}{R_B} = \frac{E_O}{4V_O},$$

where $E_O$ is the electric field strength on the centre line, and $V_O$ is the predetermined velocity.

8. An ion-beam processing system comprising an ion source (31) for emitting ions including a selected species of ions; an extraction electrode (32) for extracting an ion beam from the ion source (31); a condenser lens (33) for condensing the ion beam extracted from the ion source (31); a crossed-field velocity filter (34) according to any of the preceding claims for separating the selected species of ions from the ion beam entering therein and for focusing the separated ion beam; a separation aperture (35) for removing ions other than the selected species ions; an objective lens (36) for focusing the separated ion beam onto a target wafer (38); a beam deflector (37) for scanning the focused ion beam on the surface of the wafer; and a movable stage (39) for carrying the wafer.

## Fig. 1 A

IB

3

S

Y

X

+

−

2

Z

1

4

N

## Fig. 1 B

E

S

3

1

+

B

P

2

Y

X

N

4

## Fig. 1 C

X

Y

CS

IB

2

5

X

Y

CS'

X

1

Z

## Fig. 2A

## Fig. 2B

## Fig. 2C

## Fig. 3A

## Fig. 3B

Fig. 4